# FASCICULE DE BREVET EUROPEEN

(11) **EP 1 678 093 B1**
(45) Date de publication et mention de la délivrance du brevet: **16.06.2010**
(21) Numéro de dépôt: 04805774.9
(22) Date de dépôt: 22.10.2004
(51) Int. Cl.: C03C 17/34

(54) **SUBSTRAT, NOTAMMENT SUBSTRAT VERRIER, PORTANT UNE COUCHE A PROPRIETE PHOTOCATALYTIQUE REVETUE D UNE COUCHE MINCE PROTECTRICE**
SUBSTRAT, INSBESONDERE GLASSUBSTRAT, DAS EINE MIT EINER DÜNNEN SCHUTZSCHICHT BESCHICHTETE PHOTOKATALYTISCHE SCHICHT TRÄGT
SUBSTRATE, IN PARTICULAR GLASS SUBSTRATE, SUPPORTING A PHOTOCATALYTIC LAYER COATED WITH A PROTECTIVE THIN LAYER

(30) Priorité: 23.10.2003 FR 0350730
(43) Date de publication de la demande: 12.07.2006
(73) Titulaire: SAINT-GOBAIN GLASS FRANCE, 92400 Courbevoie (FR)
(72) Inventeur: LABROUSSE, Laurent, F-38370 Saint Prim (FR); NADAUD, Nicolas, F-94250 Gentilly (FR)
(74) Mandataire: Teyssedre, Laurent
(86) Numéro de dépôt international: PCT/FR2004/050531
(87) Numéro de publication internationale: WO 2005/040056

(56) Documents cités:
- EP-A- 1 074 525
- US-B1- 6 379 776
- PATENT ABSTRACTS OF JAPAN vol. 2000, no. 13, 5 février 2001 (2001-02-05) -& JP 2000 289134 A (NIPPON SHEET GLASS CO LTD), 17 octobre 2000 (2000-10-17)

## Description

La présente invention concerne les substrats tels que les substrats en verre, en matériau vitrocéramique ou en matière plastique qui ont été munis d'un revêtement à propriété photocatalytique pour leur conférer une fonction dite anti-salissures ou auto-nettoyante.

Une application importante de ces substrats concerne des vitrages, qui peuvent être d'applications très diverses, des vitrages utilitaires aux vitrages utilisés dans l'électroménager, des vitrages pour véhicules aux vitrages pour bâtiments.

Elle s'applique aussi aux vitrages réfléchissants du type miroir (miroir pour habitations ou rétroviseur de véhicule) et aux vitrages opacifiés du type allège.

L'invention s'applique aussi, similairement, aux substrats non transparents, comme des substrats de céramique ou tout autre substrat pouvant notamment être utilisé comme matériau architectural (métal, carrelages...). Elle s'applique de préférence, quelle que soit la nature du substrat, à des substrats sensiblement plans ou légèrement bombés.

Les revêtements photocatalytiques ont déjà été étudiés, notamment ceux à base d'oxyde de titane cristallisé sous forme anatase. Leur capacité à dégrader les salissures d'origine organique ou les micro-organismes sous l'effet de rayonnement U.V. est très intéressante. Ils ont aussi souvent un caractère hydrophile, qui permet l'évacuation des salissures minérales par projection d'eau ou, pour les vitrages extérieurs, par la pluie.

Ce type de revêtement aux propriétés anti-salissures, bactéricides, algicides, a déjà été décrit, notamment dans le brevet WO 97/10186, qui en décrit plusieurs modes d'obtention.

Si elle n'est pas protégée, la couche à propriété photocatalytique subit, au cours du temps, une usure qui se manifeste par une perte de son activité, une perte des qualités optiques de la structure (apparition d'un flou, d'une coloration), voire même par une délamination de la couche.

Si l'on diminue l'épaisseur de la couche à propriété photocalytique, la coloration susceptible d'apparaître lors d'une altération partielle de cette dernière sera moins intense et la variation de couleur sera moindre au cours du temps. Cependant, cette diminution de l'épaisseur sera au détriment de la performance de la couche.

Il est donc nécessaire d'assurer une protection mécanique et chimique de la couche, l'épaisseur de la couche protectrice devant être fine afin que la couche à propriété photocalytique conserve pleinement sa fonction.

On connaît par la demande de brevet européen EP-A-0 820 967 un élément anti-buée comprenant un substrat transparent, un film transparent d'un photocatalyseur formé sur le substrat transparent, et un film d'oxyde minéral poreux transparent formé sur le film de photocatalyseur et ayant une surface présentant une propriété hydrophile.

On connaît également par le brevet japonais JP 2002 047 032 un procédé de fabrication d'un substrat revêtu d'une membrane photocatalytique qui comprend les étapes consistant à étaler des nanoparticules de TiO₂ à structure cristalline anatase et de 5-10 nm à l'aide d'un pistolet de pulvérisation, à chauffer et à déposer par pulvérisation cathodique une membrane de SiO₂ recouvrant les particules de TiO₂.

Aucune de ces structures ne donne satisfaction, la première en raison de la nature poreuse du revêtement protecteur, lequel en raison de la présence de pores, n'assure pas une protection suffisante de la couche à propriété catalytique, et la seconde en raison d'un taux insuffisant de matière photocatalytique, laquelle ne forme pas une couche continue.

La demande JP 2000-289134 décrit une structure comprenant une couche de TiO₂ photocatalytique recouverte par une couche comprenant des particules d'oxyde métallique hydrophile dans un liant en oxyde métallique hydrophile. Cette couche est poreuse ou présente une structure en ilots.

Il est également connu de la demande EP 1 074 525 une structure comprenant une couche photocatalytique en TiO₂ surmontée par une couche hydrophile de SiO₂ de 10 nm d'épaisseur.

L'invention a d'abord pour objet une structure comprenant un substrat portant, sur au moins une partie de sa surface, une couche à propriété photocatalytique, anti-salissures, à base de dioxyde de titane (TiO₂), caractérisée par le fait que ladite couche à propriété photocatalytique est revêtue par une couche mince à teneur en silicium et en oxygène, à pouvoir couvrant, non poreuse, apte à assurer une protection mécanique et chimique de la couche photocatalytique sous-jacente en maintenant l'activité photocatalytique de TiO₂. La structure selon la présente invention est caractérisée en ce qu'elle comporte, immédiatement au-dessous de la couche à base de TiO₂, une sous-couche présentant une structure cristallographique ayant permis une assistance à la cristallisation par croissance hétéroépitaxiale dans la forme anatase de la couche supérieure à base de TiO₂, notamment constituée de ATiO₃, A désignant le baryum ou le strontium.

Les conditions de préparation de la couche à base de dioxyde de titane, telles que nature et pureté des produits de départ, solvant éventuel, traitement thermique ... devront être adaptées de manière connue en vue de l'obtention de la propriété photocatalytique, anti-salissures.

De préférence, ladite couche mince à teneur en silicium et en oxygène est présente sous la forme d'un film continu. En particulier, ladite couche mince se présente avantageusement sous la forme d'un film épousant les rugosités de surface de la couche à propriété photocatalytique sous-jacente.

La couche mince à teneur en silicium et en oxygène est notamment une couche d'au moins un composé du silicium et de l'oxygène choisi parmi SiO₂, SiOC, SiON, SiOₓ avec x<2, et SiOCH, SiO₂ étant particulièrement préféré.

Conformément à une variante intéressante de la structure selon la présente invention, la couche mince à teneur en silicium et en oxygène est une couche d'au moins un composé du silicium et de l'oxygène auquel est associé au moins un composé choisi parmi Al₂O₃ et ZrO₂, un tel composé apportant une inertie chimique et renforçant la résistance à l'hydrolyse. On peut souligner le rôle d'Al₂O₃, célèbre oxyde inerte qui augmente la tenue chimique de l'ensemble.

Le rapport atomique (Al et/ou Zr)/Si n'est généralement pas supérieur à 1, le rapport Al/Si étant avantageusement compris entre 0,03 et 0,5, en particulier entre 0,05 et 0,1, et le rapport Zr/Si, entre 0,05 et 0,4.

La couche mince à teneur en silicium et en oxygène peut avoir une épaisseur d'au plus 15 nm, notamment d'au plus 10 nm, en particulier d'au plus 8 nm, étant de préférence d'au plus 5 nm ou environ 5 nm, en particulier de 2 à 3 nm.

Ladite couche mince apporte un effet lubrifiant et a un rôle mécanique. Elle améliore la tenue à la rayure et à l'abrasion.

Cette plus grande résistance mécanique et cette meilleure tenue chimique ne sont cependant pas obtenues au détriment d'une baisse d'activité photocatalytique. En effet, alors que l'on pouvait s'attendre à ce que l'activité photocatalytique finalement obtenue de la couche à base de TiO₂ soit diminuée du fait du masquage de celle-ci par la sur-couche de SiO₂, cette activité photocatalytique est conservée et même améliorée ; en effet, les salissures, diluées dans un film uniforme de SiO₂ du fait du caractère hydrophile de ce dernier, sont plus aisément détruites par TiO₂.

La couche à base de dioxyde de titane est constituée par du TiO₂ seul ou par du TiO₂ dopé par au moins un dopant choisi notamment parmi N ; les cations pentavalents tels que Nb, Ta, V ; Fe ; et Zr. Cette couche à base de TiO₂ peut avoir été déposée par un procédé sol-gel, ou par un procédé de pyrolyse notamment en phase gazeuse, ou par pulvérisation cathodique, à température ambiante, sous vide, le cas échéant assistée par champ magnétique et/ou faisceau d'ions, avec utilisation d'une cible métallique ou TiOₓ avec x<2 et d'une atmosphère oxydante, ou avec utilisation d'une cible TiO₂ et d'une atmosphère inerte, le TiO₂ produit par la pulvérisation cathodique pouvant avoir été ensuite soumis à un traitement thermique afin de se présenter à l'état cristallisé sous une forme photocatalytiquement active.

La couche mince à teneur en silicium et en oxygène a en particulier été déposée par pulvérisation cathodique, à température ambiante, sous vide, le cas échéant assistée par champ magnétique et/ou faisceau d'ions, avec utilisation d'une cible de Si dopé Al (8% atomique) sous atmosphère Ar + O₂ à une pression de 0,2 Pa.

La structure selon la présente invention comporte, immédiatement au-dessous de la couche à base de TiO₂, une sous-couche présentant une structure cristallographique ayant permis une assistance à la cristallisation par croissance hétéroépitaxiale dans la forme anatase de la couche supérieure à base de TiO₂, notamment constituée de ATiO₃, A désignant le baryum ou le strontium. L'épaisseur de cette sous-couche n'est pas critique ; elle peut par exemple être comprise entre 10 nm et 100 nm.

Le substrat est constitué par exemple par une plaque, plane ou à faces courbes ou cintrées, de verre monolithique ou feuilleté, de matériau vitrocéramique ou d'une matière thermoplastique dure, telle que le polycarbonate, ou encore par des fibres de verre ou de vitrocéramique, lesdites plaques ou lesdites fibres ayant, le cas échéant, reçu au moins une autre couche fonctionnelle, avant l'application de la couche à base de TiO₂ ou d'une couche d'assistance à la cristallisation par croissance hétéroépitaxiale de cette dernière. (Dans le cas de plus d'une couche, on peut parler également d'empilement ou de couches).

Les applications des plaques ont été évoquées ci-dessus. Quant aux fibres, on peut citer leur application à la filtration de l'air ou de l'eau, ainsi que des applications bactéricides.

La ou les autres couches fonctionnelles sont choisies parmi les couches à fonctionnalité optique, les couches de contrôle thermique, les couches conductrices, ainsi que, dans le cas où le substrat est en verre ou en matériau vitrocéramique, les couches faisant barrière à la migration des alcalins du verre ou du matériau vitrocéramique.

Les couches à fonctionnalité optique sont notamment des couches anti-reflet, de filtration de rayonnement lumineux, de coloration, diffusante, etc.. On peut citer les couches de SiO₂, Si₃N₄, TiO₂, SnO₂, ZnO.

Les couches de contrôle thermique sont notamment les couches de contrôle solaire, ou les couches dites bas-émissives.

Les couches conductrices sont notamment les couches chauffantes, d'antenne ou anti-statiques, parmi ces couches, on peut compter les réseaux de fils conducteurs.

Dans le cas où le substrat est en verre ou matériau vitrocéramique, au moins une couche fonctionnelle faisant barrière à la migration des alcalins du verre ou du matériau vitrocéramique peut être disposée au-dessous de la sous-couche d'assistance à la cristallisation de la couche à propriété photocatalytique.

Les autres couches fonctionnelles ( à fonctionnalité optique, de contrôle thermique, couches conductrices) lorsqu'elles sont présentes se trouvent au-dessus de la ou des couches barrière.

La migration des alcalins est susceptible de résulter de l'application de températures excédant 600°C. De telles couches formant barrière aux alcalins pendant des traitements thermiques ultérieurs sont connues, et on peut citer les couches de SiO₂, SiOC, SiOₓN_{y}, Si₃N₄, d'épaisseur par exemple d'au moins 5 ou 10 nm, dans de nombreux cas d'au moins 50 nm, comme décrit dans la demande internationale PCT WO 02/24971.

A titre d'exemple, on peut mentionner les substrats en verre ou en matériau vitrocéramique, notamment de type plaques, ayant reçu une couche faisant barrière à la migration des alcalins du verre ou du matériau vitrocéramique, puis une mono-, bi- ou tricouche à fonctionnalité optique.

La présente invention a également pour objet un procédé de fabrication d'une structure telle que définie ci-dessus, selon la revendication 16.

En particulier, on effectue successivement le dépôt d'une couche de TiO₂ et celui de la couche mince à teneur en silicium et en oxygène à température ambiante, par pulvérisation cathodique sous vide, le cas échéant assistée par champ magnétique et/ou faisceau d'ions, dans la même enceinte, les conditions étant les suivantes :
- pour le dépôt de la couche à base de TiO₂, alimentation en mode à courant continu ou en courant alternatif sous une pression de 1-3 mbar, et sous atmosphère d'oxygène + gaz inerte (argon), à partir d'une cible de Ti ou TiOₓ, x = 1,5 à 2 ;
- pour le dépôt de la couche à teneur en silicium et en oxygène, une alimentation en mode à courant alternatif sous une pression de 0,1 à 1 Pa et une atmosphère Ar +

O₂ à partir d'une cible à forte teneur en silicium, le dépôt de la couche de TiO₂ étant précédé par le dépôt d'une sous-couche d'assistance à la cristallisation par croissance épitaxiale dans la forme anatase de la couche de TiO₂.

Les conditions d'un dépôt d'une couche à teneur en silicium et en oxygène qui n'est pas poreuse sont connues de l'homme du métier, étant notamment des conditions de basse pression et de forte puissance (diagramme de Thornton).

Dans le cas où l'on réalise le revêtement d'un substrat en verre ou en matériau vitrocéramique, on peut prévoir qu'avant l'application de la sous-couche associée à la couche de TiO₂, on dépose sur le substrat au moins une couche formant barrière à la migration des alcalins présents dans le verre ou le matériau vitrocéramique, un recuit ou une trempe pouvant alors être effectué après le dépôt de la couche de TiO₂ et de la couche mince à base de silicium qui la recouvre à une température comprise entre 250°C et 550°C, de préférence entre 350°C et 500°C pour le recuit, et à une température d'au moins 600°C pour la trempe.

On peut également prévoir selon l'invention qu'après l'application éventuelle d'au moins une couche formant barrière à la migration des alcalins et qu'avant l'application de la sous-couche associée à la couche de TiO₂, on dépose au moins une couche fonctionnelle choisie parmi les couches à fonctionnalité optique, les couches de contrôle thermique et les couches conductrices, lesdites couches fonctionnelles étant avantageusement déposées par pulvérisation cathodique, sous vide, le cas échéant assistée par champ magnétique et/ou faisceau d'ions.

La présente invention porte également sur un vitrage simple ou multiple en particulier pour l'automobile ou le bâtiment, comprenant sur au moins une face, une structure selon l'invention, telle que définie ci-dessus, ladite face étant notamment celle orientée vers l'extérieur, mais pouvant également être celle orientée vers l'intérieur.

Les faces de ces vitrages qui ne présentent pas la structure de la présente invention peuvent comporter au moins une autre couche fonctionnelle.

De tels vitrages trouvent leur application comme vitrage « auto-nettoyants », notamment anti-buée, anti-condensation et anti-salissures, notamment vitrage pour le bâtiment du type double-vitrage, vitrage pour véhicule du type pare-brise, lunette arrière, vitres latérales d'automobile, rétroviseur, vitrage pour train, avion, bateau, vitrage utilitaire comme verre d'aquarium, vitrine, serre, d'ameublement intérieur, de mobilier urbain (abribus, panneau publicitaire...), miroir, écran de système d'affichage du type ordinateur, télévision, téléphone, vitrage électrocommandable comme vitrage électrochrome, à cristaux liquides, électroluminescent, vitrage photovoltaïque.

### Exemples 1a et 1b (hors invention) : Empilement verre/SiO₂ :Al/TiO₂/SiO₂:Al

Sur une plaque de verre d'une épaisseur de 4 mm, on a effectué le dépôt des couches successives suivantes :
- une sous-couche de SiO₂ dopé Al de 150 nm d'épaisseur ;
- une couche de TiO₂ de 100 nm d'épaisseur (Exemple 1a) ou de 20 nm d'épaisseur (Exemple 1b) ; et
- une sur-couche de SiO₂ dopé Al de 2 nm d'épaisseur.

La sous-couche de SiO₂:Al est déposée à partir d'une cible Si:Al (8 at% d'aluminium) avec une puissance de 2000W, avec les débits gazeux suivants : 15 sccm Ar et 15 sccm O₂ et sous une pression de 2 x 10⁻³ mbar.

La couche de TiO₂ est déposée à partir d'une cible TiOₓ avec une puissance de 2000W, avec les débits gazeux suivants : 200 sccm Ar et 2 sccm O₂ et sous une pression de 23 x 10⁻³ mbar.

La surcouche de SiO₂:Al est déposée à partir d'une cible Si:Al (8 at% Al) avec une puissance de 1000W, avec les débits gazeux suivants : 15 sccm Ar et 15 sccm O₂ et sous une pression de 2 x 10⁻³ mbar.

### Exemples 2a et 2b (comparatifs) : Empilement verre/SiO₂ :Al/TiO₂

On a fabriqué les mêmes empilements qu'aux Exemples 1a et 1b, excepté que la sur-couche de SiO₂:Al a été omise.

### Exemple 3 (comparatif) : Empilement verre/SiO2:Al/TiO₂/Si₃N₄:Al

On a fabriqué le même empilement qu'à l'Exemple 1a, excepté qu'à la place de la surcouche de SiO₂:Al, on a déposé une surcouche de Si₃N₄:Al d'une épaisseur également de 2 nm à partir d'une cible Si:Al (8 at%Al) avec une puissance de 1000W, avec les débits gazeux suivants : 18 sccm Ar et 12 sccm N₂ et sous une pression de 2 x 10⁻³ mbar.

### Exemple 4 : Tenue au test Opel

On a observé une forte amélioration de la tenue au test Opel (frottement à sec de la surface de l'empilement à l'aide d'un tampon de feutre) lorsque l'on passe de l'empilement de l'Exemple 2a à l'empilement de l'Exemple 1a.

Aucun changement n'est observé lorsque l'on passe de l'empilement de l'Exemple 2a à l'empilement de l'Exemple 3.

Par ailleurs, avant et après le test Opel ci-dessus, on a évalué l'activité photocatalytique de la couche de TiO₂ de chacun des empilements des Exemples 1a, 2a et 3, selon le test de photodégradation de l'acide stéarique suivi par transmission infrarouge, décrit dans la demande internationale PCT WO 00/75087.

Les résultats sont rassemblés dans le Tableau I. Dans ce tableau figurent également la variation colorimétrique en réflexion côté couche due au test Opel ()E), le flou induit par le test Opel, et l'observation de la couche quant à sa délamination après le test Opel.

**TABLEAU I**

| Exemple | TAS (cm⁻¹.min⁻¹) | | )E | Flou (%) | Délamination |
|---|---|---|---|---|---|
| | Avant test Opel | Après test Opel | | | |
| 1a (invention) | 59 x 10⁻³ | 41 x 10⁻³ | 2,0 | 0,5 | non |
| 2a (comparatif) | 54 x 10⁻³ | 25 x 10⁻³ | 9,3 | 9,3 | oui |
| 3 (comparatif) | 40 x 10⁻³ | 15 x 10⁻³ | 10,0 | 12 | oui |

### EXEMPLE 5 : Test Taber

On a observé une amélioration de la tenue au test Taber (tenue à l'abrasion = résistance au passage d'une meule abrasive) lorsque l'on passe de l'empilement de l'Exemple 2b à l'empilement de l'Exemple 1b.

La couche de l'Exemple 2b est délaminée après 500 tours au test Taber. Pour l'empilement de l'Exemple 1b, on observe 0,8% de flou après 200 tours au test Taber et 2% de flou après 500 tours au test Taber.

### EXEMPLE 6 : Test BSN

On a observé une amélioration de la tenue au test BSN (brouillard salin neutre) lorsque l'on passe de l'empilement de l'Exemple 2a à l'empilement de l'Exemple 1a.

## Revendications

1. Structure comprenant un substrat portant, sur au moins une partie de sa surface, une couche à propriété photocatalytique, anti-salissures, à base de dioxyde de titane (TiO₂) revêtue par une couche mince à teneur en silicium et en oxygène, à pouvoir couvrant, non poreuse, apte à assurer une protection mécanique et chimique de la couche photocatalytique sous-jacente en maintenant l'activité photocatalytique de TiO₂, **caractérisée par le fait que** qu'elle comporte, immédiatement au-dessous de la couche à base de TiO₂, une sous-couche présentant une structure cristallographique ayant permis une assistance à la cristallisation par croissance hétéroépitaxiale dans la forme anatase de la couche supérieure à base de TiO₂.

2. Structure selon la revendication 1, **caractérisée par le fait que** ladite sous-couche est constituée de ATiO₃, A désignant le baryum ou le strontium.

3. Structure selon la revendication 1 ou 2, **caractérisée par le fait que** ladite couche mince à teneur en silicium et en oxygène est présente sous la forme d'un film continu.

4. Structure selon l'une des revendications 1 à 3, **caractérisée par le fait que** ladite couche mince à teneur en silicium et en oxygène se présente sous la forme d'un film épousant les rugosités de surface de la couche à propriété photocatalytique sous-jacente.

5. Structure selon l'une des revendications 1 à 4, **caractérisée par le fait que** la couche mince à teneur en silicium et en oxygène est une couche d'au moins un composé du silicium et de l'oxygène choisi parmi SiO₂, SiOC, SiON, SiOₓ avec x<2, et SiOCH.

6. Structure selon l'une des revendications 1 à 5, **caractérisée par le fait que** la couche mince à teneur en silicium et en oxygène est une couche d'au moins un composé du silicium et de l'oxygène auquel est associé au moins un composé choisi parmi Al₂O₃ et ZrO₂.

7. Structure selon la revendication 6, **caractérisée par le fait que** le rapport atomique (Al et/ou Zr)/Si n'est pas supérieur à 1.

8. Structure selon l'une des revendications 6 et 7, **caractérisée par le fait que** le rapport Al/Si est compris entre 0,03 et 0,5, en particulier entre 0,05 et 0,1.

9. Structure selon l'une des revendications 6 à 8, **caractérisée par le fait que** le rapport Zr/Si est compris entre 0,05 et 0,4.

10. Structure selon l'une des revendications 1 à 9, **caractérisée par le fait que** la couche mince à teneur en silicium et en oxygène a une épaisseur d'au plus 15 nm, notamment d'au plus 10 nm, et en particulier d'au plus 8 nm, étant de préférence d'au plus 5 nm ou environ 5 nm, en particulier de 2 à 3 nm.

11. Structure selon l'une des revendications 1 à 10, **caractérisée par le fait que** la couche à base de dioxyde de titane est constituée par du TiO₂ seul ou par du TiO₂ dopé par au moins un dopant choisi notamment parmi N ; les cations pentavalents tels que Nb, Ta, V ; Fe ; et Zr.

12. Structure selon l'une des revendications 1 à 11, **caractérisée par le fait que** la couche à base de TiO₂ a été déposée par un procédé sol-gel, ou par un procédé de pyrolyse notamment en phase gazeuse, ou par pulvérisation cathodique, à température ambiante, sous vide, le cas échéant assistée par champ magnétique et/ou faisceau d'ions, avec utilisation d'une cible métallique ou TiOₓ avec x<2 et d'une atmosphère oxydante, ou avec utilisation d'une cible TiO₂ et d'une atmosphère inerte, le TiO₂ produit par la pulvérisation cathodique pouvant avoir été ensuite soumis à un traitement thermique afin de se présenter à l'état cristallisé sous une forme photocatalytiquement active.

13. Structure selon l'une des revendications 1 à 12, **caractérisée par le fait que** la couche mince à teneur en silicium et en oxygène a été déposée par pulvérisation cathodique, à température ambiante, sous vide, le cas échéant assistée par champ magnétique et/ou faisceau d'ions, avec utilisation d'une cible de Si dopé Al (8% atomique) sous atmosphère Ar + O₂ à une pression de 0,2 Pa.

14. Structure selon l'une des revendications 1 à 13, **caractérisée par le fait que** le substrat est constitué par une plaque, plane ou à faces courbes ou cintrées, de verre monolithique ou feuilleté, de matériau vitrocéramique ou d'une matière thermoplastique dure, telle que le polycarbonate, ou encore par des fibres de verre ou de vitrocéramique, lesdites plaques ou lesdites fibres ayant, le cas échéant, reçu au moins une autre couche fonctionnelle, avant l'application de la couche d'assistance à la cristallisation par croissance hétéroépitaxiale de la couche à base de TiO₂.

15. Structure selon la revendication 14, **caractérisée par le fait que** la ou les autres couches fonctionnelles sont choisies parmi les couches à fonctionnalité optique, les couches de contrôle thermique, les couches conductrices, ainsi que, dans le cas où le substrat est en verre ou en matériau vitrocéramique, les couches faisant barrière à la migration des alcalins du verre ou du matériau vitrocéramique.

16. Procédé de fabrication d'une structure telle que définie à l'une des revendications 1 à 15, dans lequel :
- on dépose sur un substrat de verre ou de matériau vitrocéramique ou de matière plastique dure de type polycarbonate, de type plaque, ou sur des fibres de verre ou de vitrocéramique, une couche de TiO₂ éventuellement dopé que l'on soumet à un traitement thermique pour lui conférer une propriété photocatalytique dans le cas où celle-ci n'est pas apportée par les conditions utilisées pour son dépôt,
- puis l'on dépose sur ladite couche à propriété photocatalytique une couche mince à teneur en silicium et en oxygène telle que définie à l'une des revendications 1 à 10,
ledit procédé étant **caractérisé par le fait que** l'on dépose, immédiatement au-dessous de la couche à base de TiO₂, une sous-couche présentant une structure cristallographique ayant permis une assistance à la cristallisation par croissance hétéroépitaxiale dans la forme anatase de la couche supérieure à base de TiO₂.

17. Procédé selon la revendication 16, **caractérisé par le fait que** l'on effectue successivement le dépôt d'une couche de TiO₂ et celui de la couche mince à teneur en silicium et en oxygène à température ambiante, par pulvérisation cathodique sous vide, le cas échéant assistée par champ magnétique et/ou faisceau d'ions, dans la même enceinte, les conditions étant les suivantes :
- pour le dépôt de la couche à base de TiO₂, alimentation en mode à courant continu ou en courant alternatif sous une pression de 1-3 mbar, et sous atmosphère d'oxygène + gaz inerte (argon), à partir d'une cible de Ti ou TiOₓ, x = 1,5 à 2 ;
- pour le dépôt de la couche à teneur en silicium et en oxygène, une alimentation en mode à courant alternatif sous une pression de 0,1 à 1,0 Pa et une atmosphère Ar + O₂ à partir d'une cible à forte teneur en silicium ;
le dépôt de la couche de TiO₂ étant précédé par le dépôt d'une sous-couche d'assistance à la cristallisation par croissance épitaxiale dans la forme anatase de la couche de TiO₂.

18. Procédé selon l'une des revendications 16 et 17, dans lequel on réalise le revêtement d'un substrat en verre ou en matériau vitrocéramique, **caractérisé par le fait qu'**avant l'application de la sous-couche associée à la couche de TiO₂, on dépose sur le substrat au moins une couche formant barrière à la migration des alcalins présents dans le verre ou le matériau vitrocéramique, un recuit ou une trempe pouvant alors être effectué après le dépôt de la couche de TiO₂ et de la couche mince à base de silicium qui la recouvre à une température comprise entre 250°C et 550°C, de préférence entre 350°C et 500°C pour le recuit, et à une température d'au moins 600°C pour la trempe.

19. Procédé selon l'une des revendications 16 à 18, **caractérisé par le fait qu'**après l'application éventuelle d'au moins une couche formant barrière à la migration des alcalins et qu'avant l'application de la sous-couche associée à la couche de TiO₂, on dépose au moins une couche fonctionnelle choisie parmi les couches à fonctionnalité optique, les couches de contrôle thermique et les couches conductrices, lesdites couches fonctionnelles étant avantageusement déposées par pulvérisation cathodique, sous vide, le cas échéant assistée par champ magnétique et/ou faisceau d'ions.

20. Vitrage simple ou multiple, en particulier, pour l'automobile ou le bâtiment, comprenant sur au moins une face respectivement, une structure telle que définie à l'une des revendications 1 à 15, ladite face étant notamment celle orientée vers l'extérieur, mais pouvant également être celle orientée vers l'intérieur.

## Claims

1. A structure comprising a substrate bearing, on at least part of its surface, a photocatalytic antisoiling layer based on titanium dioxide (TiO₂) coated with a thin nonporous layer, containing silicon and oxygen and having a covering power, capable of mechanically and chemically protecting the underlying photocatalytic layer, while maintaining the photocatalytic activity of the TiO₂, **characterized in that** it includes, immediately below the TiO₂-based layer, an underlayer having a crystallographic structure for assisting in the crystallization, by heteroepitaxial growth, in the anatase form of the TiO₂-based upper layer.

2. The structure as claimed in claim 1, **characterized in that** the underlayer consists of ATiO₃ where A denotes barium or strontium.

3. The structure as claimed in either of claims 1 and 2,**characterized in that** said thin layer containing silicon and oxygen is present in the form of a continuous film.

4. The structure as claimed in either of claims 1 to 3, **characterized in that** said thin layer containing silicon and oxygen is present in the form of a film that conforms to the surface asperities of the underlying photocatalytic layer.

5. The structure as claimed in one of claims 1 to 4, **characterized in that** the thin layer containing silicon and oxygen is a layer of at least one silicon-oxygen compound chosen from SiO₂, SiOC, SiON, SiOₓ, where x<2, and SiOCH.

6. The structure as claimed in one of claims 1 to 5, **characterized in that** the thin layer containing silicon and oxygen is a layer of at least one silicon-oxygen compound with which at least one compound chosen from Al₂O₃ and ZrO₂ is associated.

7. The structure as claimed in claim 6, **characterized in that** the (Al and/or Zr)/Si atomic ratio does not exceed 1.

8. The structure as claimed in either of claims 6 and 7, **characterized in that** the Al/Si ratio is between 0.03 and 0.5, in particular between 0.05 and 0.1.

9. The structure as claimed in one of claims 6 to 8, **characterized in that** the Zr/Si ratio is between 0.05 and 0.4.

10. The structure as claimed in one of claims 1 to 9, **characterized in that** the thin layer containing silicon and oxygen has a thickness of at most 15 nm, especially at most 10 nm and in particular at most 8 nm, being preferably at most 5 nm, or about 5 nm, in particular 2 to 3 nm.

11. The structure as claimed in one of claims 1 to 10, **characterized in that** the titanium dioxide-based layer consists of TiO₂ alone or of TiO₂ doped with at least one dopant chosen especially from: N; pentavalent cations such as Nb, Ta and V; Fe; and Zr.

12. The structure as claimed in one of claims 1 to 11, **characterized in that** the TiO₂-based layer has been deposited by a sol-gel method or by a pyrolysis, especially chemical vapor deposition, method or by room-temperature vacuum sputtering, where appropriate magnetron and/or ion-beam sputtering, using a metal or TiOₓ target, where x<2, and in an oxidizing atmosphere, or using a TiO₂ target in an inert atmosphere, the TiO₂ produced by the sputtering then having possibly being subjected to a heat treatment so as to be in the crystallized state in a photocatalytically active form.

13. The structure as claimed in one of claims 1 to 12, **characterized in that** the thin layer containing silicon and oxygen has been deposited by room-temperature vacuum sputtering, where appropriate magnetron and/or ion-beam sputtering, using a target of Al (8 at%)-doped Si in an Ar/O₂ atmosphere at a pressure of 0.2 Pa.

14. The structure as claimed in one of claims 1 to 13, **characterized in that** the substrate consists of a sheet, whether plane or having curved faces, of monolithic or laminated glass, glass-ceramic or a hard thermoplastic, such as polycarbonate, or else of glass or glass-ceramic fibers, said sheets or said fibers having, where appropriate, received at least one other functional layer before application of the layer for assisting in the crystallization of the TiO₂-based layer by heteroepitaxial growth.

15. The structure as claimed in claim 14, **characterized in that** the functional layer or the other functional layers are chosen from layers having an optical functionality, thermal control layers and conducting layers, and also, if the substrate is made of glass or glass-ceramic, layers acting as a barrier to the migration of alkali metals from the glass or from the glass-ceramic.

16. A process for manufacturing a structure as defined in one of claims 1 to 15, **characterized in that** an optionally doped TiO₂ layer is deposited on a substrate made of glass or glass-ceramic or polycarbonate-type hard plastic, of the sheet type, or on glass or glass-ceramic fibers, said optionally doped TiO₂ layer being subjected to a heat treatment in order to give it a photocatalytic property if this is not provided by the conditions used for depositing it, and then a thin layer containing silicon and oxygen as defined in one of claims 1 to 10 is deposited on said photocatalytic layer,
said process being **characterized in that** an underlayer having a crystallographic structure for assisting in the crystallization, by heteroepitaxial growth in the anatase form of the TiO₂-based upper layer is deposited immediately below the TiO₂-based layer.

17. The process as claimed in claim 16, **characterized in that** the deposition of a TiO₂ layer and that of the thin layer containing silicon and oxygen are carried out in succession at room temperature, by vacuum sputtering, where appropriate magnetron and/or ion-beam sputtering, in the same chamber, the conditions being the following:
- for depositing the TiO₂-based layer, supply in AC or DC mode, at a pressure of 1-3 mbar and in an oxygen/inert gas (argon) atmosphere, using a Ti or TiOₓ target, where x = 1.5 to 2; and
- for depositing the layer containing silicon and oxygen, supply in AC mode at a pressure of 0.1 to 1.0 Pa and in an Ar/O₂ atmosphere using a target having a high silicon content,
the deposition of the TiO₂ layer being preceded by the deposition of an underlayer for assisting in the crystallization by epitaxial growth in the anatase form of the TiO₂ layer.

18. The process as claimed in either of claims 16 and 17, in which the coating of a glass or glass-ceramic substrate is carried out, **characterized in that**, before application of the underlayer associated with the TiO₂ layer, at least one layer forming a barrier to the migration of alkali metals present in the glass or glass-ceramic is deposited on the substrate, an annealing or toughening operation then possibly being carried out, after the TiO₂ layer and the thin silicon-based layer covering the latter have been deposited, at a temperature of between 250°C and 550°C, preferably between 350°C and 500°C, in the case of the annealing operation and at a temperature of at least 600°C in the case of the toughening operation.

19. The process as claimed in one of claims 16 to 18, **characterized in that**, after the optional application of at least one layer forming a barrier to the migration of alkali metals and before application of the underlayer associated with the TiO₂ layer, at least one functional layer chosen from layers having an optical functionality, thermal control layers and conducting layers is deposited, said functional layers being advantageously deposited by vacuum sputtering, where appropriate magnetron and/or ion-beam sputtering.

20. Single or multiple glazing, in particular for motor vehicles or buildings, comprising, on at least one face respectively, a structure as defined in one of claims 1 to 15, said face being especially that facing the outside, or possibly also that facing the inside.

## Patentansprüche

1. Struktur, die ein Substrat umfasst, das auf wenigstens einem Teil seiner Fläche eine Schicht mit photokatalytischer, schmutzabweisender Eigenschaft, auf der Basis von Titandioxid (TiO₂) trägt, die mit einer dünnen silizium- und sauerstoffhaltigen, nicht porösen Schicht mit Deckvermögen beschichtet ist, welche geeignet ist, einen mechanischen und chemischen Schutz der darunter liegenden photokatalytischen Schicht unter Aufrechterhaltung der photokatalytischen Aktivität von TiO₂ sicherzustellen, **dadurch gekennzeichnet, dass** sie direkt unter der Schicht auf TiO₂-Basis eine Unterschicht umfasst, die eine kristallographische Struktur aufweist, welche eine Kristallisationshilfe durch heteroepitaxiales Wachstum in Anatasform der oberen Schicht auf TiO₂-Basis ermöglicht hat.

2. Struktur nach Anspruch 1, **dadurch gekennzeichnet, dass** die Unterschicht aus ATiO₃ besteht, wobei A Barium oder Strontium bezeichnet.

3. Struktur nach Anspruch 1 oder 2, **dadurch gekennzeichnet, dass** die dünne silizium- und sauerstoffhaltige Schicht in Form eines durchgehenden Films vorliegt.

4. Struktur nach einem der Ansprüche 1 bis 3, **dadurch gekennzeichnet, dass** die dünne silizium- und sauerstoffhaltige Schicht in Form eines Films vorliegt, der sich den Oberflächenrauhigkeiten der darunter liegenden Schicht mit photokatalytischer Eigenschaft anpasst.

5. Struktur nach einem der Ansprüche 1 bis 4, **dadurch gekennzeichnet, dass** die dünne silizium- und sauerstoffhaltige Schicht eine Schicht aus wenigstens einer Silizium-Sauerstoff-Verbindung, ausgewählt aus SiO₂, SiOC, SiON, SiOₓ mit x < 2 und SiOCH ist.

6. Struktur nach einem der Ansprüche 1 bis 5, **dadurch gekennzeichnet, dass** die dünne silizium- und sauerstoffhaltige Schicht eine Schicht aus wenigstens einer Silizium-Sauerstoff Verbindung ist, der wenigstens eine Verbindung ausgewählt aus Al₂O₃ und ZrO₂ zugeordnet ist.

7. Struktur nach Anspruch 6, **dadurch gekennzeichnet, dass** das Atomverhältnis (Al und/oder Zr)/Si nicht größer ist als 1.

8. Struktur nach einem der Ansprüche 6 und 7, **dadurch gekennzeichnet, dass** das Verhältnis Al/Si zwischen 0,03 und 0,5, insbesondere zwischen 0,05 und 0,1 liegt.

9. Struktur nach einem der Ansprüche 6 bis 8, **dadurch gekennzeichnet, dass** das Verhältnis Zr/Si zwischen 0,05 und 0,4 liegt.

10. Struktur nach einem der Ansprüche 1 bis 9, **dadurch gekennzeichnet, dass** die dünne silizium- und sauerstoffhaltige Schicht eine Dicke von höchstens 15 nm, insbesondere von höchstens 10 nm und insbesondere von höchstens 8 nm aufweist, wobei sie vorzugsweise höchstens 5 nm oder etwa 5 nm, insbesondere 2 bis 3 nm beträgt.

11. Struktur nach einem der Ansprüche 1 bis 10, **dadurch gekennzeichnet, dass** die Schicht auf Titandioxidbasis von TiO₂ allein oder von TiO₂, das mit wenigstens einem Dotierungsmittel, insbesondere ausgewählt aus N; den fünfwertigen Kationen, wie Nb, Ta, V; Fe sowie Zr, dotiert ist, gebildet ist.

12. Struktur nach einem der Ansprüche 1 bis 11, **dadurch gekennzeichnet, dass** die Schicht auf TiO₂-Basis mittels eines Sol-Gel-Verfahrens oder mittels eines Pyrolyse-Verfahrens, insbesondere in der Gasphase, oder durch Kathodenzerstäubung, bei Raumtemperatur, unter Vakuum, gegebenenfalls magnetfeld- und/oder ionenstrahlgestützt, unter Verwendung eines Metall- oder TiOₓ-Targets, mit x < 2, und einer oxidierenden Atmosphäre oder unter Verwendung eines TiO₂-Targets und einer inerten Atmosphäre, abgeschieden worden ist, wobei das durch die Kathodenzerstäubung erzeugte TiO₂ anschließend einer Wärmebehandlung unterzogen worden sein kann, um in kristallisiertem Zustand in einer photokatalytisch aktiven Form vorzuliegen.

13. Struktur nach einem der Ansprüche 1 bis 12, **dadurch gekennzeichnet, dass** die dünne silizium- und sauerstoffhaltige Schicht durch Kathodenzerstäubung, bei Raumtemperatur, unter Vakuum, gegebenenfalls magnetfeld- und/oder ionenstrahlgestützt, unter Verwendung eines Al-dotierten Si-Targets (8 Atomprozent), unter Ar + O₂-Atmosphäre, bei einem Druck von 0,2 Pa abgeschieden worden ist.

14. Struktur nach einem der Ansprüche 1 bis 13, **dadurch gekennzeichnet, dass** das Substrat von einer ebenen oder gekrümmte oder gebogene Flächen aufweisenden Platte aus monolithischem Glas oder Verbundglas, aus glaskeramischem Material oder einem harten Thermoplast, wie Polycarbonat, oder aber von Glas- oder Glaskeramikfasern gebildet ist, wobei die Platten oder die Fasern gegebenenfalls wenigstens eine weitere funktionelle Schicht, vor Auftragen der Schicht zur Unterstützung der Kristallisation durch heteroepitaxiales Wachstum der Schicht auf TiO₂-Basis aufgenommen haben.

15. Struktur nach Anspruch 14, **dadurch gekennzeichnet, dass** die weitere(n) funktionelle(n) Schicht(en) aus den Schichten mit optischer Funktionalität, den Thermokontrollschichten, den leitenden Schichten, sowie - in dem Fall, in dem das Substrat aus Glas oder glaskeramischem Material besteht - den Schichten, welche die Migration der Alkalien des Glases oder des glaskeramischen Materials behindern.

16. Verfahren zur Herstellung einer Struktur, wie sie in einem der Ansprüche 1 bis 15 definiert ist, bei dem:
- auf einem Substrat aus Glas oder glaskeramischem Material oder hartem Kunststoff vom Typ Polycarbonat, von der Art Platte, oder auf Glas- oder Glaskeramikfasern eine Schicht aus eventuell dotiertem TiO₂ abgeschieden wird, die einer Wärmebehandlung unterzogen wird, um ihr eine photokatalytische Eigenschaft in dem Fall zu verleihen, in dem diese nicht durch die für ihr Abscheiden verwendeten Bedingungen bereitgestellt wird,
- anschließend auf der Schicht mit photokatalytischer Eigenschaft eine dünne silizium- und sauerstoffhaltige Schicht, wie sie in einem der Ansprüche 1 bis 10 definiert ist, abgeschieden wird,
wobei das Verfahren **dadurch gekennzeichnet ist, dass** direkt unter der Schicht auf TiO₂-Basis eine Unterschicht abgeschieden wird, die eine kristallographische Struktur aufweist, welche eine Kristallisationshilfe durch heteroepitaxiales Wachstum in Anatasform der oberen Schicht auf TiO₂-Basis ermöglicht hat.

17. Verfahren nach Anspruch 16, **dadurch gekennzeichnet, dass** nacheinander das Abscheiden einer TiO₂-Schicht und das der dünnen silizium- und sauerstoffhaltigen Schicht bei Raumtemperatur, durch Kathodenzerstäubung unter Vakuum, gegebenenfalls magnetfeld- und/oder ionenstrahlgestützt, in dem gleichen Raum vollzogen wird, wobei die Bedingungen folgende sind:
- für das Abscheiden der Schicht auf TiO₂-Basis, Versorgung im Gleichstrom- oder Wechselstrommodus, unter einem Druck von 1 bis 3 mbar sowie unter einer Atmosphäre aus Sauerstoff und Inertgas (Argon), mittels eines Targets aus Ti oder TiOₓ, x = 1,5 bis 2,
- für das Abscheiden der silizium- und sauerstoffhaltigen Schicht, eine Versorgung im Wechselstrommodus, unter einem Druck von 0,1 bis 1,0 Pa und einer Ar- + O₂-Atmosphäre, mittels eines stark siliziumhaltigen Targets,
wobei dem Abscheiden der TiO₂-Schicht das Abscheiden einer Unterschicht zur Unterstützung der Kristallisation durch epitaxiales Wachstum in Anatasform der TiO₂-Schicht vorausgeht.

18. Verfahren nach einem der Ansprüche 16 und 17, bei dem die Beschichtung eines Substrats aus Glas oder glaskeramischem Material vollzogen wird, **dadurch gekennzeichnet, dass** vor dem Auftragen der der TiO₂-Schicht zugeordneten Unterschicht wenigstens eine die Migration der in dem Glas oder dem glaskeramischen Material vorhandenen Alkalien hemmende Schicht auf dem Substrat abgeschieden wird, wobei dann ein Glühen oder ein Härten nach dem Abscheiden der TiO₂-Schicht und der dünnen Schicht auf Siliziumbasis, welche diese bedeckt, durchgeführt werden kann, bei einer Temperatur zwischen 250°C und 550°C, vorzugsweise zwischen 350°C und 500°C für das Glühen und bei einer Temperatur von wenigstens 600°C für das Härten.

19. Verfahren nach einem der Ansprüche 16 bis 18, **dadurch gekennzeichnet, dass** nach dem eventuellen Auftragen wenigstens einer die Migration der Alkalien hemmenden Schicht und vor dem Auftragen der der TiO₂-Schicht zugeordneten Unterschicht wenigstens eine funktionelle Schicht, welche aus den Schichten mit optischer Funktionalität, den Thermokontrollschichten und den leitenden Schichten ausgewählt ist, aufgetragen wird, wobei die funktionellen Schichten vorteilhafterweise durch Kathodenzerstäubung, unter Vakuum, gegebenenfalls magnetfeld-und/oder ionenstrahlgestützt abgeschieden werden.

20. Einfach- oder Mehrfachglas, insbesondere für den Kraftfahrzeugbereich oder das Bauwesen, das auf wenigstens einer Fläche jeweils eine Struktur aufweist, wie sie in einem der Ansprüche 1 bis 15 definiert ist, wobei die Fläche insbesondere die nach außen gewandte ist, aber auch die nach innen gewandte sein kann.
